# EUROPÄISCHE PATENTSCHRIFT

(11) **EP 2 476 004 B1**
(45) Veröffentlichungstag und Bekanntmachung des Hinweises auf die Patenterteilung: **03.07.2013**
(21) Anmeldenummer: 10732667.0
(22) Anmeldetag: 08.07.2010
(51) Int. Cl.: G01R 31/327

(54) **Prüfantrieb für Stufenschalter**
Test drive for tap changer
Actionneur de test pour commutateur à gradins

(30) Priorität: 08.09.2009 DE 202009012198 U
(43) Veröffentlichungstag der Anmeldung: 18.07.2012
(73) Patentinhaber: Maschinenfabrik Reinhausen GmbH, 93025 Regensburg (DE)
(72) Erfinder: BIERINGER, Alfred, 94333 Geiselhöring (DE)
(86) Internationale Anmeldenummer: PCT/EP2010/004166
(87) Internationale Veröffentlichungsnummer: WO 2011/029494

(56) Entgegenhaltungen:
- WO-A1-01/92978
- WO-A1-2008/024048
- DE-B3-102004 052 316
- DE-C1- 19 530 776
- US-A- 4 159 446

## Beschreibung

Die Erfindung betrifft einen Prüfantrieb zur Überprüfung eines Stufenschalters oder eines Umstellers im Rahmen von Prüfungen des zu regelnden Transformators.

Stufenschalter dienen zur unterbrechungslosen Umschaltung zwischen Wicklungsanzapfungen eines Stufentransformators. Sie sind seit vielen Jahren in zahlreichen Ausführungsformen bekannt, z. B. aus der Firmendruckschrift der Anmelderin "VACUTAP® VR-Laststufenschalter für Regeltransformatoren", Druckimpressum IN206/09de-0708/1000.

Der dort beschriebene Stufenschalter besteht aus einem in einem separaten Ölgefäß untergebrachten Lastumschalter und einem darunter angeordneten Wähler.

Der Wähler dient zur leistungslosen Vorwahl der neuen Wicklungsanzapfung des Stufentransformators, auf die umgeschaltet werden soll; der Lastumschalter dient zur nachfolgenden, schnellen, unterbrechungslosen eigentlichen Umschaltung von der bisherigen auf die neue Wicklungsanzapfung.

Der gesamte Stufenschalter wird von einem Motorantrieb bei der Umschaltung betätigt. Eine sich drehende Antriebswelle bewegt kontinuierlich den Wähler, gleichzeitig wird ein Kraftspeicher des Lastumschalters aufgezogen. Ist er vollständig aufgezogen, d. h. gespannt, wird er entklinkt, gibt seine Energie schlagartig frei und betätigt schnell, d. h. im ms-Bereich, den Lastumschalter.

Die Lastumschalter können abhängig von der Transformatorenausführung, an die sie angeschlossen werden sollen, der verwendeten Schaltung sowie anderen Gerätespezifika unterschiedlich sein. Bei der beschriebenen Lastumschaltung vollführt der Lastumschalter eine spezifische Schaltsequenz, d. h. verschiedene mechanische Kontakte und/oder auch Vakuumschaltröhren werden in bestimmter zeitlicher Reihenfolge nacheinander bzw. überlappend betätigt.

Dazu ist am oberen Bereich des Stufenschalters, am Deckel, eine obere Getriebestufe vorgesehen, die im montierten Zustand des Stufenschalters mit einer Antriebswelle eines üblicherweise seitlich an der Außenwand des Transformators befestigten Motorantriebes gekoppelt ist.

Umsteller dienen im Gegensatz dazu zur lastlosen Umschaltung zwischen Wicklungsanzapfungen eines dazu abgeschalteten Stufentransformators. Sie sind ebenfalls in zahlreichen Ausführungsformen bekannt, z. B. aus der Firmendruckschrift der Anmelderin "DEETAP® DU-Umsteller" Druckimpressum IN277/01de-0705/500.

Umsteller besitzen ebenfalls an ihrem oberen Bereich einen Deckel, an dem ebenfalls eine obere Getriebestufe vorgesehen ist, die im montierten Zustand des Umstellers mit einer Antriebswelle des Motorantriebes oder in vielen Fällen hier auch eines Handantriebes gekoppelt ist.

US 4 159 446 offenbart einen Prüfantrieb zur Überprüfung eines Stufenschalters.

Vor Inbetriebnahme des Stufenschalters bzw. des Umstellers und dem Zuschalten des Stufentransformators sind zahlreiche Überprüfungen und Messungen, z. B. Widerstands- und Übersetzungsmessungen erforderlich, die sich umständlich gestalten, eben weil der Stufenschalter oder der Umsteller noch nicht mit dem Motorantrieb oder dem Handantrieb, der ihn später betätigen wird, verbunden ist.

Aufgabe der Erfindung ist es, einen Prüfantrieb der eingangs genannten Art anzugeben, mit dem am separaten Stufenschalter oder Umsteller Einzelschaltungen, das Anfahren einer vorbestimmten Position oder auch ein definierter kompletter Prüfzyklus durchgeführt werden können. Dabei soll die erfindungsgemäße Vorrichtung universell verwendbar sein, d. h. ohne großen Aufwand an Stufenschalter bzw. Umsteller unterschiedlichster Bauart, insbesondere unterschiedlicher Zahl möglicher Stufenstellungen, mit unterschiedlichen technischen Daten usw. anpassbar sein.

Diese Aufgabe wird durch die Erfindung gelöst. Die nebengeordneten Patentansprüche 1 und 2 betreffen Prüfantriebe der eingangs genannten Art; die Unteransprüche betreffen vorteilhafte Weiterbildungen.

Die allgemeine erfinderische Idee besteht darin, dass ein Prüfantrieb einen Servomotor, besitzt, der über ein Getriebe auf einen Adapter wirkt, der mit der oberen Getriebestufe eines Stufenschalters oder Umstellers zeitweise verbindbar ist, wobei der Prüfantrieb eine Steuereinheit aufweist. Dabei werden von der Steuereinheit die stufenschalter- bzw. umstellerspezifischen Daten abgerufen und verarbeitet.

Solche schalterspezifischen Daten sind insbesondere:
- Justierstellung
- Drehrichtung höher/tiefer
- Zahl der Umdrehungen/Schaltung der Getriebestufe
- Schaltertyp
- Seriennummer
- Anzahl der Stellungen und -bereiche
- Umkehrwert
- Maximal zulässige Drehmomentgrenzwerte.

Bei einer ersten Realisierungsform dieser allgemeinen erfinderischen Idee gemäß Patentanspruch 1 ist am Prüfantrieb eine RFID-Antenne vorgesehen, die mit einem RFID-Tag am Stufenschalter oder Umsteller korrespondiert, auf dem die schalterspezifischen Daten nicht flüchtig gespeichert sind. Bei dieser Realisierungsform ist demnach eine, allerdings unproblematische, zusätzliche Ausrüstung des jeweiligen Stufenschalters oder Umstellers mit einem RFID-Tag am bzw. auf dem Kopfdeckel erforderlich. RFID's sind inzwischen etablierte Bauelemente, die klein und preiswert verfügbar sind. Hier dient der jeweilige RFID dazu, alle stufenschalterspezifischen Daten zu speichern und für eine Parametrierung verfügbar zu halten.

Alternativ sind statt eines RFID grundsätzlich auch Barcodes o. ä. möglich, die jedoch bei verschiedenen Anwendungsfällen Nachteile aufweisen, wie z. B. mögliche Verschmutzung und in der Folge schlechte Ablesbarkeit. Außerdem ist die Informationsdichte solcher Barcodes geringer.

Bei einer zweiten Realisierungsform dieser allgemeinen erfinderischen Idee gemäß Patentanspruch 2 sind die schalterspezifischen Daten hingegen in der Steuereinheit selbst oder in mit ihr zusammenwirkenden Speichermedien nicht flüchtig gespeichert. Solche Speichermedien können z.B CD oder USB-Stick sein. Es ist auch möglich, eine Konkordanzliste der zu den jeweiligen vom Hersteller vergebenen Seriennummern gehörenden schalterspezifischen Daten zu speichern.

Gemäß einer vorteilhaften Weiterbildung der Erfindung kann die Steuereinheit auch Mittel zur manuellen Eingabe der schalterspezifischen Daten aufweisen, etwa wenn der RFID-Tag fehlt oder das Speichermedium defekt ist.

Nachfolgend soll die Erfindung an Hand von Figuren noch näher erläutert werden. Es zeigen:
- Figur 1: einen erfindungsgemäßen Prüfantrieb, hier an einem Stufenschalter, in schematischer Darstellung
- Figur 2: ein Beispiel eines tatsächlich an einem Stufenschalter montierten derartigen Prüfantriebes.

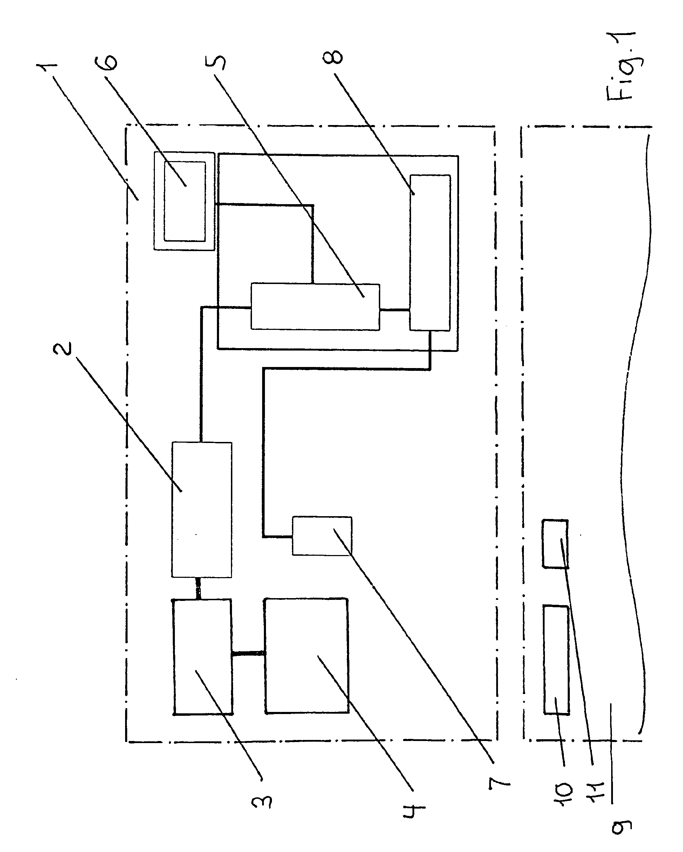

Zunächst soll an Hand der Darstellung in Figur 1 der prinzipielle Aufbau eines neuartigen Prüfantriebes näher erläutert werden. Der gesamte Prüfantrieb 1 ist hier von einer symbolischen Strichlinie umgeben. Er besitzt einen Servomotor 2, der über ein Getriebe 3 auf einen Adapter 4 wirkt. Ferner besitzt der Prüfantrieb eine Steuereinheit 5, die mit einer Bedieneinheit 6 zusammenwirkt. Weiterhin ist eine RFID-Antenne 7 vorgesehen, die über einen RFID-Reader 8 ebenfalls mit der Steuereinheit 5 verbunden ist. Unterhalb des Prüfantriebes 1 ist hier noch, ebenfalls schematisch, der obere Teil eines Stufenschalters 9 gezeigt. Dort ist eine obere Getriebestufe 10 angedeutet, mit der der weiter oben erwähnte Adapter 4 verbunden werden kann. Ferner ist der ebenfalls erwähnte RFID-Tag 11 gezeigt, der die Informationen über die stufenschalterspezifischen Daten trägt und von der RFID-Antenne 7 ausgelesen werden kann.

Im montierten Zustand des Prüfantriebes 1 korrespondiert also dessen Adapter 4 mit der oberen Getriebestufe 10 des Stufenschalters sowie dessen RFID-Antenne 7 berührungslos mit dem RFID-Tag 11 des Stufenschalters.

Der Servomotor 2 mit Getriebe 3, Adapter 4 und RFID-Antenne 7 kann besonders vorteilhaft als integrierte Gesamteinheit auf der oberen Getriebestufe 10 des Stufenschalters in einfacher Weise adaptiert werden. Durch eine formschlüssige Auslegung des Adapters 4 kann an der oberen Getriebestufe 10 das dort erforderliche Drehmoment aufgebracht werden.

Sobald der RFID-Tag 11 in die Lesereichweite der RFID-Antenne 7 gelangt, werden die Parametrierungsdaten, d. h. spezifischen Stufenschalterdaten, über den RFID-Reader 8 ausgelesen und der Steuereinheit 5 übergeben. An der Bedieneinheit 6, die auf besonders vorteilhafte Weise als Touchpanel ausgebildet ist, werden die ausgewählten Daten, wie beispielweise Typ- und Seriennummer angezeigt.

Nachfolgend muss die Justierstellung bestätigt werden. Anschließend erfolgt eine erste Probeschaltung, um die Schaltrichtung des jeweiligen Stufenschalters "höher" bzw. "tiefer" eindeutig zu bestimmen.

Damit ist die Prüfvorrichtung einsatzbereit. Es können jetzt Einzelschaltungen oder das Anfahren einer bestimmten Zielposition durchgeführt werden. Ebenso ist es möglich, einen vordefinierten Prüfzyklus ablaufen zu lassen.

Auf einfache Weise sind somit alle erforderlichen Messungen und Prüfungen am jeweiligen Stufenschalter oder Umsteller, insbesondere auch alle Widerstands- und Übersetzungsmessungen, im Zusammenspiel mit dem jeweiligen Stufentransformator möglich.

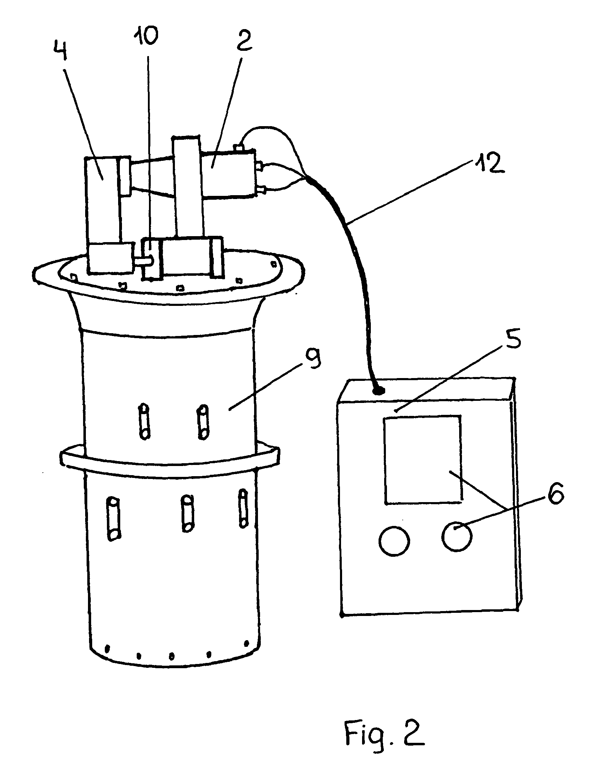

Figur 2 zeigt eine tatsächliche Anordnung eines erfindungsgemäßen Prüfantriebes an einem Stufenschalter 9. Zu sehen sind der Servomotor 2, der Adapter 4, der mit der oberen Getriebestufe 10 des Stufenschalters 9 korrespondiert, sowie rechts die Steuereinheit 5 in einem Schaltschrank. Zusätzlich gezeigt ist hier eine Verbindungsleitung 12 von der Steuereinheit 5 hin zum Servomotor 2.

Es ist im Rahmen der Erfindung auch möglich, den Prüfantrieb auf drei Säulen zu erweitern, um mit einem Aufbau das Schalten von drei Stufenschaltern gleichzeitig zu ermöglichen und somit eine rationelle Prüfung des Transformators zu gewährleisten.

Weiterhin ist es möglich, einen zeitlichen Drehmomentverlauf der entsprechenden Stufenschalterbetätigung entweder direkt in der Steuereinheit 5 oder durch eine zusätzliche Drehmomenterfassung zu bewerten bzw. auszuwerten. Damit ist ein Vergleich mit einem vorab ermittelten "Fingerprint" des jeweiligen Stufenschalters bei der vorangegangenen Stückprüfung beim Hersteller möglich. Hierdurch können Fehler durch Verspannungen oder Falscheinbauten erfasst und vor Inbetriebnahme beseitigt werden. Dies ist auch bei Umstellern möglich. Der Drehmomentverlauf kann dabei direkt gemessen werden oder auch aus der Leistungsaufnahme des Servomotors 2 errechnet werden.

Hierzu ist es sinnvoll, wenn die relevanten Werte des jeweiligen "Fingerprints" nach der Stückprüfung mit auf dem RFID-Tag 11 des Stufenschalters oder dem Speichermedium der Steuereinheit 5 gespeichert werden, so dass sie später für einen Vergleich zur Verfügung stehen.

Weiterhin ist es möglich, den erfindungsgemäßen Prüfantrieb als Komplettsystem zur automatisierten Widerstands- und Übersetzungsmessung für Transformatoren mit Stufenschaltern auszubauen. Auch diese erweiterten Möglichkeiten sind gleichermaßen für Umsteller realisierbar.

Schließlich ist es im Rahmen der Erfindung möglich, an der Steuereinheit 5 zusätzliche Steuereingänge zu Integration in bestehende Steuereinrichtungen oder etwa zur Fernbedienung vorzusehen.

## Patentansprüche

1. Prüfantrieb zur Überprüfung eines Stufenschalters oder eines Umstellers im Rahmen der Prüfungen des zugeordneten zu regelnden Transformators,
wobei der Prüfantrieb (1) einen Elektromotor besitzt, der mit dem Stufenschalter (9) oder dem Umsteller zeitweise verbindbar ist,
wobei der Prüfantrieb (1) weiterhin eine Steuereinheit (5) aufweist, die mit einer Bedieneinheit (6) zusammenwirkt,
**dadurch gekennzeichnet,**
**dass** der Elektromotor ein Servomotor (2) ist,
**dass** der Servomotor (2) über ein Getriebe (3) mit einem Adapter (4) mechanisch verbunden ist, dass der Adapter (4) mit einer oberen Getriebestufe (10) des Stufenschalters (9) oder Umstellers formschlüssig verbindbar ist,
**dass** am Prüfantrieb (1) eine RFID-Antenne (7) vorgesehen ist, die mit einem RFID-Tag (11) am Stufenschalter (9) bzw. Umsteller korrespondiert, auf dem die schalterspezifischen Daten nicht flüchtig gespeichert sind, derart, dass diese Daten in der RFID-Antenne (7) auslesbar sind und dass die RFID-Antenne (7) über einen RFID-Reader (8) ebenfalls mit der Steuereinheit (5) in elektrischer Verbindung steht.

2. Prüfantrieb nach Anspruch 1,
**dadurch gekennzeichnet,**
**dass** Servomotor (2), Getriebe (3), Adapter (4) und RFID-Antenne (7) als integrierte Gesamteinheit auf der oberen Getriebestufe (10) des Stufenschalters (9) oder Umstellers adaptierbar sind.

3. Prüfantrieb nach Anspruch 1 oder 2,
**dadurch gekennzeichnet,**
**dass** drei identische Prüfantriebe vorgesehen sind, derart, dass eine gleichzeitige Prüfung von drei Stufenschalter bzw. Umstellern möglich ist.

4. Prüfantrieb nach einen der Ansprüche 1-3,
**dadurch gekennzeichnet,**
**dass** zusätzliche Mittel zur Erfassung des Drehmomentverlaufes während der Umschaltung vorhanden sind.

5. Prüfantrieb nach Anspruch 4,
**dadurch gekennzeichnet,**
**dass** zusätzliche Mittel zum Vergleich des erfassten Drehmomentverlaufes während der Umschaltung mit einem vorab nicht flüchtig gespeicherten spezifischen Sollwert des jeweiligen Stufenschalters (9) bzw. Umstellers vorgesehen sind.

## Claims

1. Test drive for checking an on-load tap changer or an off-load tap changer within the scope of tests of the associated transformer to be regulated,
wherein the test drive (1) comprises an electric motor (2) which is periodically connectible with the on-load tap changer (9) or off-load tap changer and
wherein the test drive (1) further comprises a control unit (5) co-operating with an operating unit (6),
**characterised in that**
the electric motor is a servomotor (2),
the servomotor (2) is mechanically connected with an adapter (4) by way of a transmission (3),
the adapter (4) is mechanically positively connectible with a top transmission stage (10) of the on-load tap changer or off-load tap changer,
provided at the test drive (1) is an RFID antenna (7) co-operating with an RFID tag (11) at the on-load tap changer (9) or off-load on-load tap changer, on which tag the changer-specific data are stored in non-volatile manner in such a manner that these data can be read out in the RFID antenna (7) and
the RFID antenna (7) is similarly electrically connected with the control unit (5) by way of an RFID reader (8).

2. Test drive according to claim 1, **characterised in that** the servomotor (2), transmission (3), adapter (4) and RFID antenna (7) are adaptable as an integrated complete unit to the top transmission stage (10) of the on-load tap changer (9) or off-load tap changer.

3. Test drive according to claim 1 or 2, **characterised in that** three identical test drives are provided in such a manner that a simultaneous testing of three on-load tap changers or off-load tap changers is possible.

4. Test drive according to any one of claims 1 to 3, **characterised in that** additional means for detecting the torque plot during switching-over are present.

5. Test drive according to claim 4, **characterised in that** additional means for comparison of the detected torque plot during the switching over with a specific target value, which was stored in non-volatile manner beforehand, of the respective on-load tap changer or off-load tap changer are provided.

## Revendications

1. Actionneur de test pour un changeur de prises ou un commutateur dans le cadre d'essais faits sur des transformateurs de réglage, l'actionneur de test (1) comportant un moteur électrique qui peut être relié périodiquement au changeur de prises (9) ou au commutateur,
- actionneur de test (1) ayant en outre une unité de commande (5) coopérant avec une unité de service (6),
**caractérisé en ce que**
- le moteur électrique est un servomoteur (2),
- le servomoteur (2) est relié mécaniquement à un adaptateur (4) par une transmission (3),
- l'adaptateur (4) est relié par une liaison par la forme à un étage de transmission supérieure (10) du changeur de prise (9) ou du commutateur,
- l'actionneur de test (1) comporte une antenne RFID (7) qui coopère avec une étiquette RFID (11) du changeur de prises (9) ou du commutateur qui enregistre de manière non volatile les données spécifiques au changeur de façon que ces données puissent être lues par l'antenne RFID (7), et
- l'antenne RFID (7) est reliée électriquement par un lecteur RFID (8) également à l'unité de commande (5).

2. Actionneur de test selon la revendication 1,
**caractérisé en ce que**
le servomoteur (2), la transmission (3), l'adaptateur (4) et l'antenne RFID (7) constituent un ensemble intégré dans l'étage de transmission supérieure (10) du changeur de prises (9) ou du commutateur.

3. Actionneur de test selon la revendication 1 ou 2,
**caractérisé par**
trois actionneurs identiques pour permettre un contrôle simultané de trois changeurs de prises ou commutateurs.

4. Actionneur de test selon l'une des revendications 1 à 3,
**caractérisé par**
des moyens supplémentaires pour détecter l'évolution du couple pendant la commutation.

5. Actionneur de test selon la revendication 4,
**caractérisé par**
des moyens supplémentaires pour comparer la courbe de couple saisie pendant la commutation avec une valeur de consigne spécifique enregistrée préalablement d'une manière non volatile pour le changeur de prises (9) ou le commutateur respectif.
